(19) Europäisches Patentamt

European Patent Office

Office européen des brevets

(11) EP 0 695 066 A2

## (12) EUROPÄISCHE PATENTANMELDUNG

(43) Veröffentlichungstag:
31.01.1996 Patentblatt 1996/05

(51) Int. Cl.⁶: $H04L\ 27/04$

(21) Anmeldenummer: 95108686.7

(22) Anmeldetag: 07.06.1995

(84) Benannte Vertragsstaaten:
DE FR GB IT

(30) Priorität: 29.07.1994 DE 4426935

(71) Anmelder: Rohde & Schwarz GmbH & Co. KG
D-81671 München (DE)

(72) Erfinder:
• Buchwald, Wolf-Peter, Prof. Dr.-Ing.
D-38173 Evessen/Hachum (DE)
• Hentschel, Christian, Dr.-Ing.
D-38106 Braunschweig (DE)

• Harm, Hartwig, Dr.-Ing.
D-85540 Haar (DE)
• Geier, Gerhard, Dipl.-Ing.
D-81739 München (DE)
• Schlange, Hans-Ulrich, Dipl.-Ing.
D-81673 München (DE)
• Fischer, Walter, Dipl.-Ing. (FH)
D-85368 Moosburg (DE)

(74) Vertreter: Graf, Walter, Dipl.-Ing.
D-81667 München (DE)

### (54) Digitaler Modulator für Videosignale

(57) Zur Modulation eines Trägers mit einem digitalen Videosignal wird ein digitaler Doppel-Gegentakt-Modulator verwendet, dem eingangsseitig das durch Abtasten mit einer Abtastfrequenz $f_a$ digitalisierte Videosignal zugeführt wird und der mit der halben Abtastfrequenz $f_a/2$ des Videosignals als Trägerfrequenz getaktet ist, so daß jeder zweite Abtastwert des Videosignals invertiert wird.

EP 0 695 066 A2

# Beschreibung

Die Erfindung betrifft einen Modulator zum Modulieren eines Trägers mit einem digitalen Videosignal.

In der Fernsehtechnik besteht in zunehmendem Maße Bedarf an Modulatoren, die digital arbeiten und damit unmittelbar digitale Videosignale umsetzen können.

Zur Übertragung von Videosignalen wird beispielsweise die sogenannte Restseitenband-Amplitudenmodulation angewendet, bei der eines der entstehenden Seitenbänder vollständig und das andere Seitenband nur teilweise mit relativ langsam abfallender Amplitude nach höheren Modulationsfrequenzen hin übertragen wird (siehe beispielsweise Schönfelder, Nachrichtentechnik, Justus von Liebig Verlag, Darmstadt, Abschnitt IX oder Mäusl, Fernsehtechnik, Hüthig Buchverlag Heidelberg, Seiten 16 bis 19). Hierfür werden bisher ausschließlich analoge Modulatoren benutzt. Ein ähnliches Problem besteht bei einem Single-Frequency-Network (SFN), bei dem alle Sender ein identisches Signal zeitgleich abstrahlen. Um Laufzeitunterschiede der über Satelliten-Strecken übertragenen COFDM- (Coded-Orthogonal-Frequency-Division and Multiplexing) codierten Videosignale auszugleichen werden in jedem Sender digitale Verzögerungsschaltungen eingesetzt. Auch hier ist für die anschließende Umsetzung des im Basisband vorliegenden digitalen Videosignals auf die Sendefrequenz des SFN ein digitaler Modulator erforderlich.

Es ist daher Aufgabe der Erfindung, einen Modulator zum Modulieren eines Trägers mit einem digitalen Videosignal zu schaffen, der digital arbeitet.

Diese Aufgabe wird durch einen Modulator laut Hauptanspruch gelöst. Vorteilhafte Weiterbildungen ergeben sich aus den Unteransprüchen.

Durch die Verwendung eines Doppelgegentaktmodulators, der mit der halben Abtastfrequenz des zugeführten digitalen Videosignals getaktet wird, ergibt sich ein besonders einfacher Aufbau, da der Träger nicht als digitales Sinussignal aufbereitet werden muß, es genügt, den Umschalter des Doppelgegentaktmodulators im Takt der halben Abtastfrequenz umzuschalten. Die Trägerfrequenz entspricht dabei der halben Abtastfrequenz des Videosignals. Ein solcher Doppelgegentaktmodulator besitzt darüber hinaus noch die vorteilhafte Eigenschaft, daß nur noch die beiden AM-Seitenbänder ohne Träger entstehen und auch das ursprüngliche Basisband-Videosignal nicht mehr im Ausgangsspektrum erscheint. Lediglich eventuelle Gleichanteile im Videosignal (Grauwerte) erzeugen eine entsprechende Trägeramplitude. Im Ausgangssignal ist also das zu modulierende Videosignal nicht mehr additiv dem Trägerfrequenzsignal überlagert, dadurch ist es möglich, mit relativ einfachen digitalen Filtern das jeweils gewünschte modulierte Nutzsignal auszufiltern. Die Verwendung von digitalen Filtern ermöglicht einen besonders einfachen und preiswerten Aufbau eines Restseitenband-Modulators, da die nach der Fernsehnorm erforderlichen steilflankigen Restseitenbandfilter (beispielsweise nach CCIR-Norm und beschrieben im Datenblatt 341001 der Firma Rohde & Schwarz auf Seiten 10 und 11) mit nach der Norm vorgegebenen sehr engen Toleranzen in Digitaltechnik sehr exakt realisiert werden können. Bei Verwendung eines erfindungsgemäßen Modulators als Einseitenband-Modulator, wie dies bei den Sendern eines SFN zweckmäßig ist, werden entsprechend bemessene digitale Einseitenbandfilter eingesetzt. Für die Realisierung dieser Digitalfilter gibt es nach den Unteransprüchen verschiedene Möglichkeiten als Tiefpaß-, Hochpaß- bzw. Bandpaßfilter.

Der erfindungsgemäße digitale Modulator besitzt darüber hinaus den besonderen Vorteil, daß für seinen Betrieb eine relativ niedrige Abtastfrequenz benutzt werden kann, an seine Verarbeitungsgeschwindigkeit also relativ geringe Ansprüche gestellt werden, so daß er mit den derzeit handelsüblichen digitalen Bauelementen einfach und preiswert realisiert werden kann. Es ist lediglich erforderlich, daß die gewählte Abtastfrequenz für das Videosignal, durch die gleichzeitig auch die Umschaltfrequenz des Doppelgegentaktmodulators bestimmt ist, größer als die doppelte Bandbreite des Videosignals (2 x 5 MHz) gewählt wird, nach oben hin besteht im Prinzip keine Beschränkung. Um jedoch mit möglichst geringer digitaler Arbeitsgeschwindigkeit auszukommen ist es vorteilhaft, die Abtastfrequenz kleiner als 20 MHz zu wählen. Verschiedene besonders vorteilhafte Bemessungsvorschriften für die Abtastfrequenz ergeben sich aus den Unteransprüchen. Wenn mit relativ niedriger Abtastfrequenz und damit auch Trägerfrequenz des Modulators gearbeitet wird, genügt es, mittels eines nachfolgenden üblichen analogen Mischers das digital erzeugte Restseitenbandsignal auf die gewünschte Ausgangsfrequenz, beispielsweise die derzeit übliche Zwischenfrequenz von 38,9 MHz hochzumischen.

Ein erfindungsgemäßer digitaler Modulator ist nicht nur sehr einfach und preiswert herstellbar, er besitzt gegenüber den bisher üblichen analogen Modulatoren auch noch den Vorteil, daß er in dem einmal gewählten Aufbau exakt reproduzierbar ist, keine Abgleicharbeiten erfordert und seine Charakteristik auch nicht durch Temperaturänderungen oder dergleichen beeinflußt wird.

Die Erfindung wird im folgenden anhand schematischer Zeichnungen an Ausführungsbeispielen eines Restseitenband-Modulators näher erläutert.

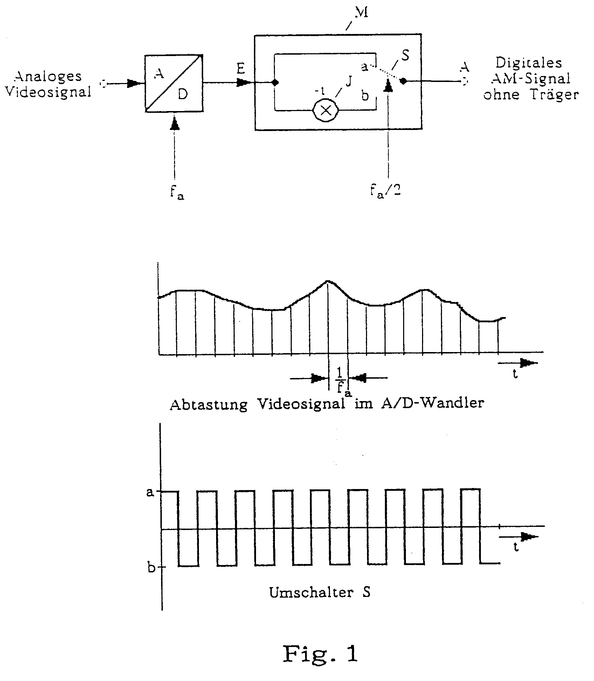

Fig. 1 zeigt das Prinzipschaltbild eines erfindungsgemäßen digitalen AM-Restseitenbandmodulators in Form eines Doppelgegentaktmodulators M, der die Eigenschaft besitzt, nur noch die beiden Seitenbänder ohne das ursprüngliche Basisband-Videosignal im Ausgangsspektrum zu erzeugen. In Fig. 1 ist diese digitale Wirkungsweise eines Doppelgegentaktmodulators schematisch mit einem Umschalter S dargestellt, mit welchem das am Eingang E zugeführte digitale Videosignal abwechselnd direkt bzw. über einen Inverter J invertiert dem Ausgang A zugeführt wird. Das digitale Videosignal wird aus dem analog zugeführten Videosignal in einem A/D-Wandler erzeugt, der mit einer Abtastfre-

quenz $f_a$ getaktet ist oder das digitale Videosignal wird unmittelbar in digitaler Form erzeugt mit einer Abtastfrequenz $f_a$ dem Eingang E zugeführt. Der Doppelgegentaktmodulator M ist mit der halben Abtastfrequenz getaktet, d.h. sein Umschalter S wird im Takt $f_a/2$ periodisch zwischen a und b umgeschaltet, wie dies schematisch in dem Umschaltschema nach Fig. 1 dargestellt ist. Aus der Beziehung zwischen der in Fig. 1 schematisch angedeuteten Abtastung des Videosignals und dieser mit halber Frequenz erfolgenden Umschaltung des Schalters S ergibt sich, daß jeder zweite Abtastwert des Videosignals invertiert wird, dies entspricht einer Amplitudenmodulation mit der Trägerfrequenz $f_a/2$, ohne daß dazu ein entsprechend aufwendig digital erzeugtes Sinussignal für den Träger notwendig ist, die Modulation mit dem Träger erfolgt nur durch Umschaltung des Schalters S. Damit ergibt sich ein besonders einfacher Aufbau. Theoretisch läßt sich diese Wirkungsweise mit der Modulation des Videosignals mit einem Träger mit der halben Abtastfrequenz beschreiben. Als Besonderheit liegen die beiden Seitenbänder symmetrisch zur Nyquist-Frequenz.

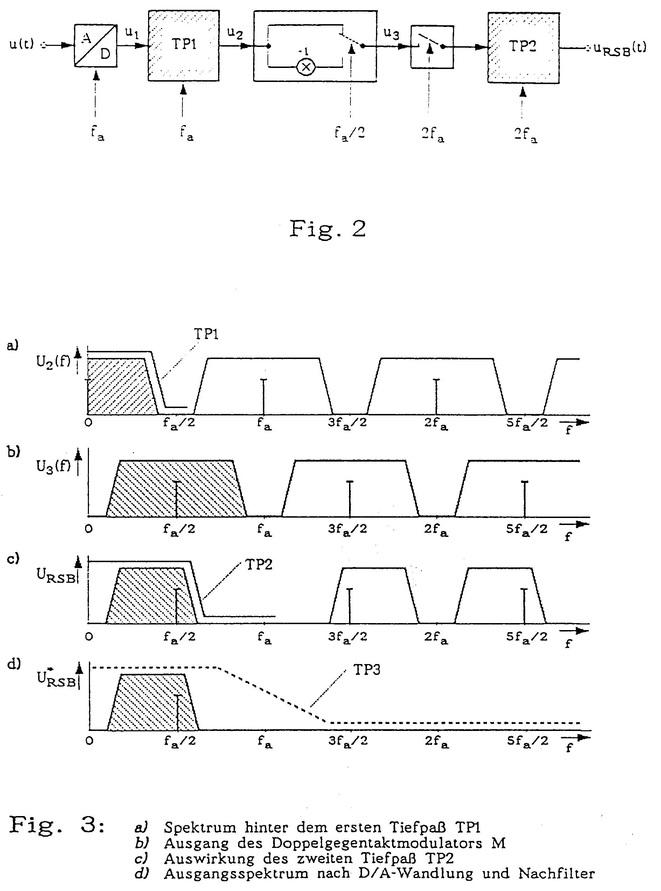

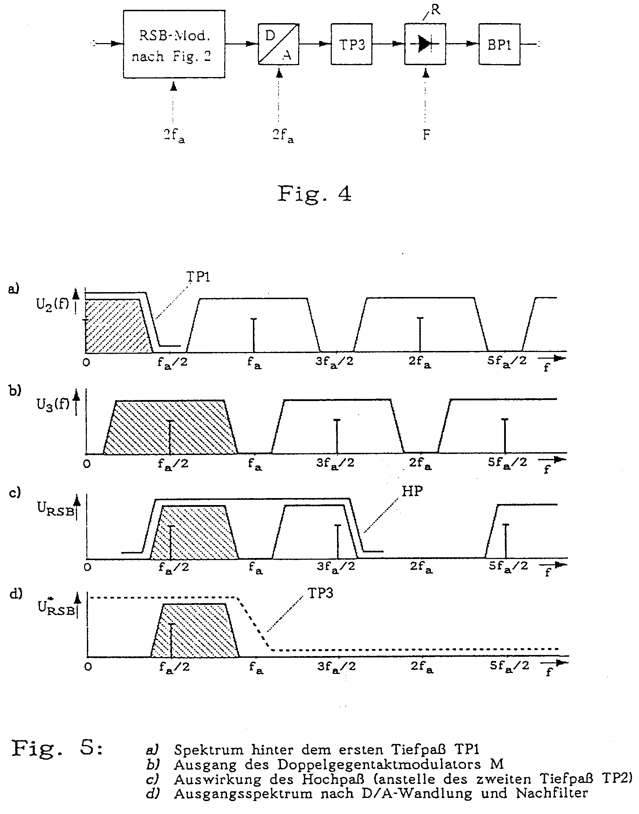

Um die bei der digitalen Modulation entstehende Doppelseitenband-AM in eine RSB-AM zu überführen sind dem Doppelgegentaktmodulator nach Fig. 1 noch zusätzliche digitale Filter zugeordnet, deren Amplitudencharakteristik den Restseitenbandfilter-Normvorschriften entsprechen. Fig. 2 zeigt die Realisierung dieses Restseitenbandfilters mit zwei Tiefpässen TP1 und TP2, Fig. 3 zeigt das zugehörige Diagramm. Das mit der Abtastfrequenz $f_a$ erzeugte digitale Videosignal u1 wird dem Tiefpaß TP1 zugeführt, der ebenfalls mit der Abtastfrequenz $f_a$ getaktet ist. Die Filtercharakteristik dieses Tiefpasses TP1 ist so gewählt, daß nach dem Modulator M neben dem oberen Seitenband auch der Frequenzgang des unteren Seitenbandes in gespiegelter Form bestimmt ist, wie dies Fig. 3b zeigt. Die Tiefpaßfunktion des Tiefpasses TP1 wird damit in eine Hochpaßcharakteristik transformiert. Am Ausgang des Modulators M ist ein zweiter Tiefpaß TP2 angeordnet, der das obere Seitenband gemäß Fig. 3c so begrenzt, daß ein unsymmetrisches Restseitenband entsteht. Da dieses zweite Tiefpaßfilter TP2 jedoch übergreifend über die bisherige Nyquist-Frequenz wirken muß, ist eine Abtastratenänderung erforderlich, beispielsweise eine Verdopplung der Abtastrate auf $2f_a$. Dazu ist gemäß Fig. 2 zwischen Modulator M und Tiefpaß TP2 eine Schaltung zum Einfügen von Abtastwerten der Amplitude Null mit der Taktfrequenz $2f_a$ vorgesehen, so daß virtuell ein Datenstrom der doppelten Abtastfrequenz entsteht. Der Tiefpaß TP2 kann dann mit der doppelten Abtastfrequenz $2f_a$ getaktet werden. Das zweifache Berücksichtigen jedes Abtastwertes durch Wiederholung erhöht zwar die Leistung des resultierenden Signals, stellt jedoch in sich bereits eine Filterung dar, die einem cosinusförmigen Frequenzgang mit einfacher Nullstelle bei der ursprünglichen Abtastfrequenz $f_a$ entspricht. Durch das zweite Tiefpaßfilter TP2 wird also das obere Seitenband des trägerfrequenten Videosignalspektrums nach der Videonorm geformt, zusammen mit der gespiegelten Charakteristik des ersten Tiefpasses TP1 ergibt sich ein resultierender Bandpaß, dessen Gesamtcharakteristik der vorgeschriebenen Restseitenbandfilter-Norm entspricht, wobei die Trägerfrequenz $f_a/2$ ist (entspricht der Zwischenfrequenz 38,9 MHz der Restseitenbandfilter nach Datenblatt 341001). Das so digital erzeugte digitale Restseitenbandsignal gemäß Fig. 3c mit der Trägerfrequenz $f_a/2$ wird gemäß Fig. 4 einem D/A-Wandler zugeführt und über ein analoges Tiefpaßfilter TP3 werden störende Oberwellen abgesiebt.

Der Tiefpaß TP1 muß eine Durchlaßcharakteristik von 0 bis $f_{g1}$ bei entsprechender Welligkeit des zu realisierenden Bandpasses (RSB-Filtertoleranz) aufweisen, so daß sich hierfür eine untere Bandpaßgrenzfrequenz von $f_{gu} = f_a/2 - f_{g1}$ ergibt. Der Tiefpaß TP2 ist entsprechend mit einer Grenzfrequenz von $f_{g2}$ so zu dimensionieren, daß sich eine obere Bandpaßgrenzfrequenz $f_{go} = f_{g2}$ ergibt. Daraus und den gegebenen Werten für den Toleranzschlauch des nach der Norm vorgegebenen Restseitenbandfilters sind diese beiden Tiefpaßfilter zu entwerfen.

Da in diesem Beispiel das Restseitenbandsignal nach Fig. 3d mit relativ niedrigerer Abtastfrequenz $f_a$ von nur etwas mehr als der doppelten Videobandbreite erzeugt wird ist es nötig, zusätzlich noch eine analoge Frequenzumsetzung beispielsweise auf die genormte Zwischenfrequenz von 38,9 MHz vorzunehmen, dies geschieht gemäß Fig. 4 beispielsweise mit einem Mischer R, der mit einer geeigneten Trägerfrequenz F gespeist ist, über ein nachgeschaltetes Bandpaßfilter BP1 werden die nicht benutzten Seitenbänder weggefiltert.

Fig. 5 zeigt die Realisierung mit einem vorgeschalteten Tiefpaß TP1 gemäß Fig. 2, jedoch mit einem nach dem Modulator M angeordneten Hochpaß HP. Das hierfür notwendige analoge Tiefpaß-Nachfilter TP3 muß hier mit einer steileren Filterflanke realisiert werden, da das erste Oberwellenband näher am Nutzband liegt.

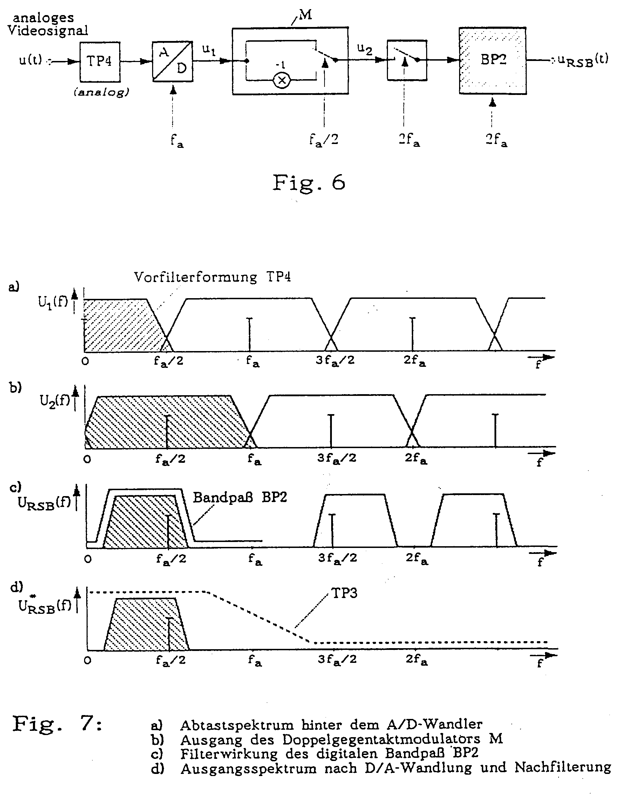

Fig. 6 und 7 zeigen die Realisierung des digitalen Filters unmittelbar als Bandpaß BP2. Diese direkte Realisierung des Filters als Bandpaß setzt voraus, daß dessen Taktfrequenz wieder mit der doppelten Abtastfrequenz $2f_a$ getaktet wird. Außerdem ist hier die Charakteristik des analogen Vorfilters in Form eines Tiefpasses TP4 dargestellt. Die Spektraldarstellung nach Fig. 7 zeigt, daß das analoge Vorfilter TP4 Bandüberlappungen zulassen darf, d.h. bei der Nyquist-Frequenz $f_a/2$ ist noch keine sehr hohe Sperrdämpfung zu fordern. Diese Eigenschaft gilt analog bei der Verwendung zweier Tiefpässe zur RSB-Bandpaßrealisierung.

Wie sich aus den Spektrumsdarstellungen ergibt, muß die Abtastfrequenz $f_a$ größer als die doppelte Bandbreite (2 x 5 MHz) des Videosignals gewählt werden, andererseits soll sie aus Gründen der billigen Realisierbarkeit möglichst klein sein. Würde die Abtastfrequenz beispielsweise zu 20 MHz gewählt, was einer Trägerfrequenz von 10 MHz entspricht, so wäre für den zweiten Tiefpaß TP2 bzw. Bandpaß BP2 eine Abtastfrequenz von 40 MHz erforderlich, was in üblicher TTL-Technik nur schwer zu realisieren ist. Aus diesem Grunde ist es vorteilhaft, eine Abtastfrequenz unter 25 MHz zu benutzen. Als erste Möglichkeit bietet sich an, die Abtastfrequenz $f_a$ entsprechend der für die Digitalisierung von Videosignalen nach CCIR-Norm 601 festgelegten Abtastfrequenz von 13,5 MHz zu wählen. Damit ist der erfindungsgemäße Modulator mit externen digitalen Studiogeräten unmittelbar kompatibel, ein nach der Norm erzeugtes digitales Videosignal kann unmittelbar am Eingang E des Modulators eingespeist werden, ein zusätzlicher A/D-Wandler ist überflüssig.

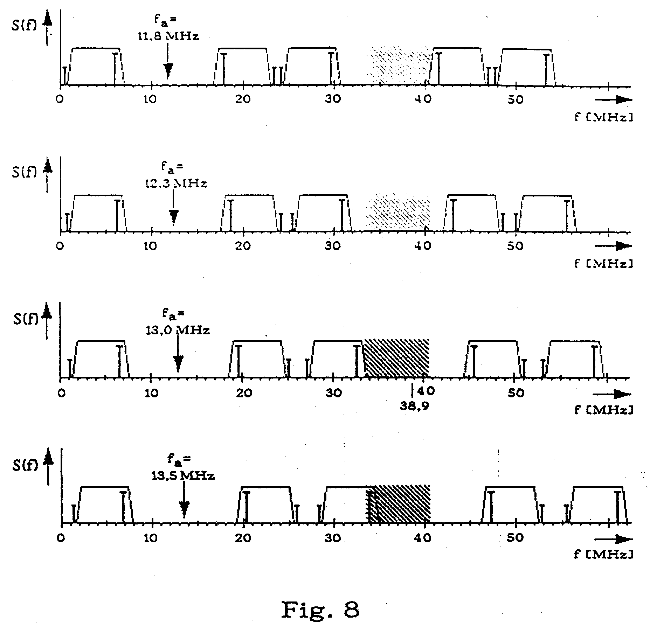

In manchen Anwendungfällen kann es vorteilhaft sein, die Abtastfrequenz nach anderen Gesichtspunkten zu wählen, beispielsweise gemäß Fig. 8 so, daß die bei der Modulation entstehenden Oberwellenspektren nicht das vorgesehene endgültige Trägerfrequenzspektrum nach einer abschließenden analogen Kochmischung überlagern. Ist beispielsweise die Erzeugung eines endgültigen Trägerfrequenzspektrums in der genormten ZF-Lage mit einem Träger von 38,9 MHz gewünscht, so wird gemäß Fig. 8 mit einer Abtastfrequenz $f_a$ = 12,3 MHz ein Oberwellenspektrum erzeugt, das in der gewünschten in Fig. 8 schraffiert dargestellten Trägerfrequenzlage frei ist und das gemäß Fig. 4 auf 38,9 MHz hochgemischte Trägerfrequenzspektrum also nicht durch Oberwellen des Modulationsspektrums gestört ist.

Eine andere Möglichkeit ist, die Taktfrequenz $f_a$ entsprechend einer gewünschten endgültigen Trägerfrequenz zu wählen. Besonders günstig sind hierbei ganzzahlige Verhältnisse. Zur Modulation eines Videosignals auf die Norm-ZF von 38,9 MHz bietet sich beispielsweise eine Abtastfrequenz von 1/3 x 38,9 = 12,97 MHz an. Durch eine phasenstarre Verkopplung werden Störungen durch Oberwellen praktisch nicht wirksam. Anders herum kann ausgehend von einer vorher festgelegten Abtastfrequenz von z.B. 13,5 MHz eine modifizierte gewünschte Trägerlage von z.B. 3 x 13,5 = 40,5 MHz gewählt werden.

Ein weiterer Vorteil des erfindungsgemäßen digitalen Modulators besteht darin, gezielt die bei der Modulation entstehenden Oberwellenbänder für die Erzeugung des gewünschten Trägerfrequenzspektrums auszunutzen, die hinter dem D/A-Wandler nach dem Modulator vorhanden sind. Wenn beispielsweise gemäß Fig. 3c die Taktfrequenz $f_a$ so gewählt wird, daß das bei $5f_a/2$ entstehende Oberwellenspektrum mit der gewünschten Trägerfrequenz übereinstimmt, kann dieses Spektrum $5f_a/2$ hinter dem D/A-Wandler unmittelbar mit einem entsprechend dimensionierten Bandpaß ausgesiebt werden. Ist beispielsweise eine endgültige Trägerfrequenzlage für das Nutzspektrum bei 38,9 MHz erwünscht, so wird dies mit einer Abtastfrequenz $f_a$ = 38,9 : 2,5 = 15,56 MHz erreicht.

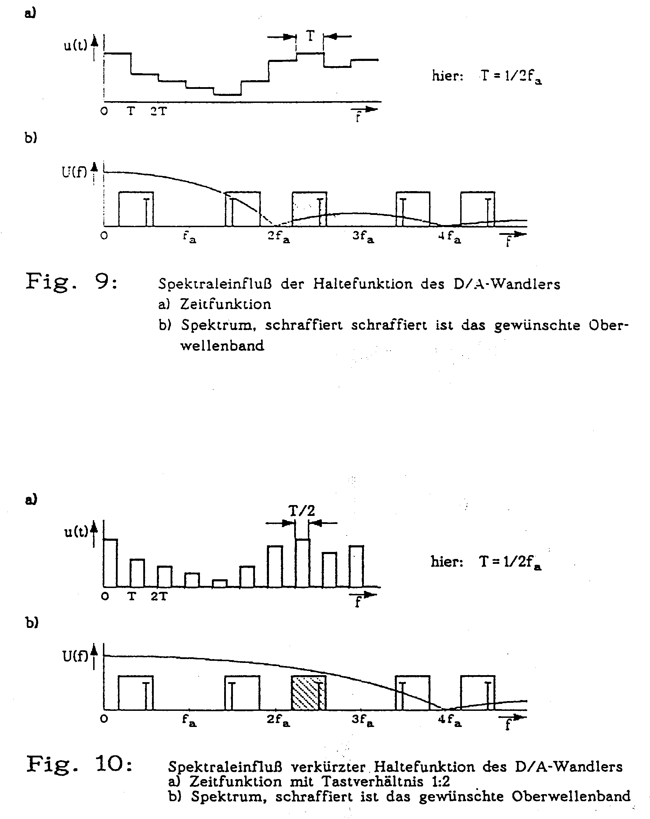

Der nachgeschaltete D/A-Wandler besitzt eine siförmige Nachfilterwirkung, die normalerweise Nullstellen bei der Abtastfrequenz und ihren Vielfachen aufweist und die dieser vorteilhaften Ausnutzung der erzeugten Oberwellen entgegensteht. Fig.9 zeigt schematisch diesen Frequenzgang in Überlagerung zum unbewerteten Abtastspektrum. Diese störende Filterwirkung kann durch eine Erhöhung der Abtastfrequenz vor dem D/A-Wandler in Verbindung mit zusätzlich eingefügten Nullamplituden zwischen den eigentlichen Abtastwerten verringert werden, dadurch wird ein pulsamplitudenmoduliertes Ausgangssignal eines D/A-Wandlers mit kleinerer Haltefunktion erreicht, die eine schwächere Nachfiltereigenschaft besitzt, indem die Nullstellen zu höheren Frequenzen hin verschoben werden, wie dies Bild 10 zeigt.

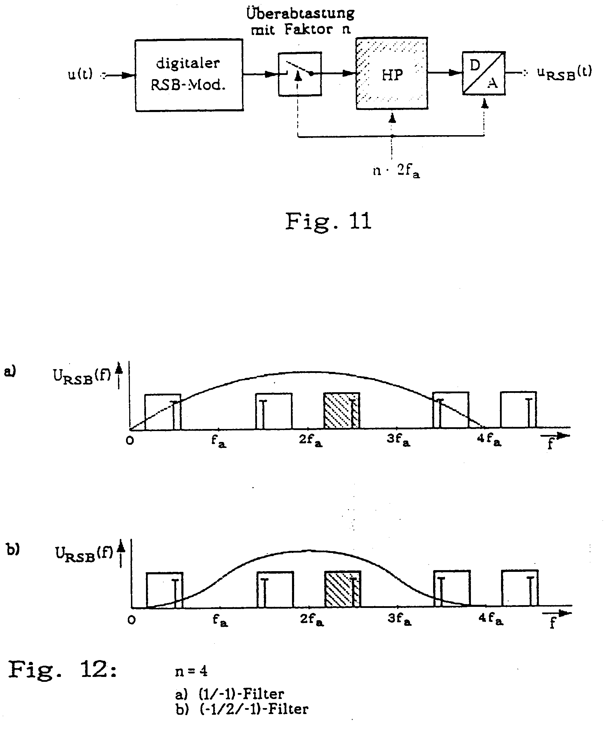

Zusätzlich zu dieser Erhöhung der Taktfrequenz kann gemäß Fig. 11 vor dem D/A-Wandler ein mit der gleichen erhöhten Taktfrequenz getaktetes digitales Hochpaßfilter HP1 vorgesehen werden, hierdurch wird die Signalenergie des gewünschten Spektrums angehoben. Fig. 12 zeigt, wie auf diese Weise beispielsweise durch ein sogenanntes (1-1)-Hochpaßfilter (Fig. 12a) bzw. ein sogenanntes digitales (-1/2/-1)-Filter sehr vorteilhafte Frequenzgänge durch Erhöhung der Taktfrequenz des D/A-Wandlers erzeugt werden können und zwar durch Vervierfachung der Taktfrequenz für den D/A-Wandler und auch für den Hochpaß HP1 (n = 4).

Eine andere Anwendungsmöglichkeit für einen erfindungsgemäßen rein digital arbeitenden Modulator besteht bei der Umsetzung eines im Basisband von 0,4 bis 8 MHz vorliegenden COFDM-codierten Videosignals auf die Sendefrequenz eines SFN-Senders, wie dies zur Aufbereitung der Videosignale in den einzelnen Sendern eines Single-Frequency-Network's erforderlich ist. Hier wird das COFDM-codierte Videosignal, das beispielsweise durch eine frequenzmodulierte Satellitenstrecke allen SFN-Sendern zugeführt wird, in einer digitalen Verzögerungsschaltung, die mit einer Abtastfrequenz $f_a$ von beispielsweise 20 MHz arbeitet, über Speicherketten digital verzögert und anschließend in einem erfindungsgemäßen Modulator mit Hilfe einer Zwischenfrequenz von z.B. 30 bis 40 MHz auf die gewünschte Sendefrequenz der SFN-Sender umgesetzt. Dazu wird im digitalen Doppel-Gegentakt-Modulator das entsprechend zeitverzögerte digitale Videosignal mit einer Trägerfrequenz von 10 MHz, die also wieder halb so groß wie die Abtastfrequenz $f_a$ in der Verzögerungsschaltung gewählt ist, auf die ZF-Frequenz umgesetzt. Durch digitale Filter wird das obere Seitenband zwischen 30 und 40 MHz der zweiten Wiederholung des Spektrums als ZF herausgefiltert. Dies kann entweder durch einen Bandpaß mit einer 4-fachen Abtastfrequenz von 80 MHz durchgeführt werden oder wieder durch einen Tiefpaß mit einer Abtastfrequenz von 20 MHz vor dem Modulator und einem Tiefpaß mit der 4-fachen Abtastfrequenz von 80 MHz nach dem Modulator, wie dies anhand der vorhergehenden Fig. auch bezüglich des Restseitenband-Modulators beschrieben ist. Das ZF-Signal wird dann mit einem üblichen analogen Mischer auf die eigentliche Sendefrequenz des SFN-Senders umgesetzt.

**Patentansprüche**

1. Modulator zum Modulieren eines Trägers mit einem Videosignal, **gekennzeichnet** durch einen digitalen Doppel-Gegentakt-Modulator (M), dem eingangsseitig das durch Abtasten mit einer Abtastfrequenz ($f_a$) digitalisierte Videosignal zugeführt wird und der mit der halben Abtastfrequenz ($f_a/2$) des Videosignals als Trägerfrequenz getaktet ist, so daß jeder zweite Abtastwert des Videosignals invertiert wird.

2. Modulator nach Anspruch 1, dadurch **gekennzeichnet,** daß dem digitalen Doppel-Gegentakt-Modulator (M) ein digitales Seitenband-Filter zugeordnet ist.

3. Modulator nach Anspruch 2, dadurch **gekennzeichnet,** daß das digitale Restseitenband-Filter durch einen vor dem Doppel-Gegentakt-Modulator (M) angeordneten und mit der Abtastfrequenz ($f_a$) des Videosignals getakteten ersten Tiefpaß (TP1) und einen nach dem Doppel-Gegentakt-Modulator (M) angeordneten, mit der mehrfachen Abtastfrequenz ($2f_a$) getakteten zweiten Tiefpaß (TP2) gebildet ist (Fig. 2).

4. Modulator nach Anspruch 2, dadurch **gekennzeichnet,** daß das digitale Seitenband-Filter durch einen vor dem Modulator angeordneten Tiefpaß (TP1) und einen nach dem Modulator angeordneten Hochpaß (HP) gebildet ist (Fig. 5).

5. Modulator nach Anspruch 2, dadurch **gekennzeichnet,** daß das digitale Seitenband-Filter durch einen nach dem Modulator (M) angeordneten Bandpaß (BP2) gebildet ist, der mit der mehrfachen Abtastfrequenz ($2f_a$) getaktet ist (Fig. 6).

6. Modulator nach einem der vorhergehenden Ansprüche, dadurch **gekennzeichnet,** daß die Abtastfrequenz ($f_a$) des Videosignals größer als die doppelte Bandbreite des Videosignals gewählt ist.

7. Modulator nach einem der vorhergehenden Ansprüche, dadurch **gekennzeichnet,** daß die Abtastfrequenz kleiner als 25 MHz gewählt ist.

8. Modulator nach einem der vorhergehenden Ansprüche, dadurch **gekennzeichnet,** daß die Abtastfrequenz ($f_a$) ein ganzzahliger Bruchteil der gewünschten endgültigen Trägerfrequenz ist.

9. Modulator nach einem der vorhergehenden Ansprüche, dadurch **gekennzeichnet,** daß nach dem D/A-Wandler, mit dem das digital erzeugte Seitenband in ein analoges Seitenbandsignal gewandelt wird, ein zusätzliches analoges Tiefpaßfilter (TP3) angeordnet ist.

10. Modulator nach einem der vorhergehenden Ansprüche, dadurch **gekennzeichnet,** daß das mit niedriger Abtastfrequenz ($f_a$) und damit niedriger Trägerfrequenz ($f_a/2$) erzeugte Seitenbandsignal nach D/A-Wandlung mittels eines analogen Mischers (R) auf die gewünschte Ausgangsfrequenz, insbesondere die Norm-Zwischenfrequenz (38,9 MHz), hochgemischt wird.

11. Modulator nach einem der vorhergehenden Ansprüche, dadurch **gekennzeichnet,** daß die Abtastfrequenz ($f_a$) so gewählt ist (z.B. 15,56 MHz), daß der Träger eines der erzeugten Oberwellenspektren (z.B. $5f_a/2$) mit der gewünschten Trägerfrequenz (z.B. 38,9 MHz) übereinstimmt und dieses Oberwellenspektrum nach der D/A-Wandlung mit einem entsprechend bemessenen Bandpaßfilter ausgefiltert wird.

12. Modulator nach einem der vorhergehenden Ansprüche, dadurch **gekennzeichnet,** daß der D/A-Wandler mit einer gegenüber der Abtastfrequenz ($2f_a$) des ausgangsseitigen Digitalfilters (TP2 bzw. BP2) n-fach höheren Taktfrequenz getaktet ist.

13. Modulator nach Anspruch 13, dadurch **gekennzeichnet,** daß vor dem D/A-Wandler ein digitales Hochpaßfilter (HP1) angeordnet ist, das mit der gleichen n-fach höheren Abtastfrequenz getaktet ist.

14. Als Restseitenband-Modulator arbeitender Modulator nach einem oder mehreren der vorhergehenden Ansprüche, dadurch **gekennzeichnet,** daß dem digitalen Doppelgegentakt-Modulator (M) ein in seiner Amplitudencharakteristik nach der Fernseh-Norm bemessenes und auf die halbe Abtastfrequenz ($f_a/2$) als Träger bezogenes digitales Restseitenband-Filter zugeordnet ist.

15. Modulator nach Anspruch 14, dadurch **gekennzeichnet,** daß die Abtastfrequenz ($f_a$) entsprechend der Norm für die Digitalisierung von Videosignalen gewählt ist (13,5 MHz).

16. Modulator nach Anspruch 14, dadurch **gekennzeichnet,** daß die Abtastfrequenz ($f_a$) so gewählt ist (z.B. 12,3 MHz), daß die Oberwellen des Abtastspektrums nicht im Spektrumsbereich der gewünschten endgültigen Trägerfrequenz liegen (Fig. 8).

Abtastung Videosignal im A/D-Wandler

Umschalter S

Fig. 1

Fig. 2

Fig. 3:  a) Spektrum hinter dem ersten Tiefpaß TP1
        b) Ausgang des Doppelgegentaktmodulators M
        c) Auswirkung des zweiten Tiefpaß TP2
        d) Ausgangsspektrum nach D/A-Wandlung und Nachfilter

Fig. 4

Fig. 5: a) Spektrum hinter dem ersten Tiefpaß TP1
b) Ausgang des Doppelgegentaktmodulators M
c) Auswirkung des Hochpaß (anstelle des zweiten Tiefpaß TP2)
d) Ausgangsspektrum nach D/A-Wandlung und Nachfilter

analoges
Videosignal

u(t) → [TP4] → [A/D] →$u_1$→ [M ⊗ -1 →$u_2$] → [  ] → [BP2] →$u_{RSB}(t)$

(analog)

$f_a$    $f_a/2$    $2f_a$    $2f_a$

## Fig. 6

a) $U_1(f)$

Vorfilterformung TP4

0    $f_a/2$    $f_a$    $3f_a/2$    $2f_a$    $f$

b) $U_2(f)$

0    $f_a/2$    $f_a$    $3f_a/2$    $2f_a$    $f$

c) $U_{RSB}(f)$

Bandpaß BP2

0    $f_a/2$    $f_a$    $3f_a/2$    $2f_a$    $f$

d) $\overset{*}{U}_{RSB}(f)$

TP3

0    $f_a/2$    $f_a$    $3f_a/2$    $2f_a$    $f$

Fig. 7:
a) Abtastspektrum hinter dem A/D-Wandler
b) Ausgang des Doppelgegentaktmodulators M
c) Filterwirkung des digitalen Bandpaß BP2
d) Ausgangsspektrum nach D/A-Wandlung und Nachfilterung

EP 0 695 066 A2

Fig. 8

a)

u(t)

hier:   T = 1/2f$_a$

O   T   2T

b)

U(f)

O        f$_a$        2f$_a$        3f$_a$        4f$_a$

Fig. 9:    Spektraleinfluß der Haltefunktion des D/A-Wandlers
           a) Zeitfunktion
           b) Spektrum, schraffiert schraffiert ist das gewünschte Ober-
              wellenband

a)

T/2

u(t)

hier:   T = 1/2f$_a$

O   T   2T

b)

U(f)

O        f$_a$        2f$_a$        3f$_a$        4f$_a$

Fig. 10:   Spektraleinfluß verkürzter Haltefunktion des D/A-Wandlers
           a) Zeitfunktion mit Tastverhältnis 1:2
           b) Spektrum, schraffiert ist das gewünschte Oberwellenband

Fig. 11

Fig. 12:     n = 4
a) (1/-1)-Filter
b) (-1/2/-1)-Filter